# EUROPEAN PATENT SPECIFICATION

(11) **EP 2 589 068 B1**
(45) Date of publication and mention of the grant of the patent: **28.09.2016**
(21) Application number: 11804092.2
(22) Date of filing: 27.06.2011
(51) Int. Cl.: C01B 33/035, H01L 21/205, C23C 16/24, C23C 16/44, C23C 16/46

(54) **SYSTEM AND METHOD OF SEMICONDUCTOR MANUFACTURING WITH ENERGY RECOVERY**
SYSTEM UND VERFAHREN ZUR HALBLEITERHERSTELLUNG MIT ENERGIERÜCKGEWINNUNG
SYSTÈME ET PROCÉDÉ DE FABRICATION DE SEMI-CONDUCTEUR AVEC RÉCUPÉRATION D'ÉNERGIE

(30) Priority: 29.06.2010 US 826446
(43) Date of publication of application: 08.05.2013
(73) Proprietor: GTAT Corporation, Merrimack, NH 03054 (US)
(72) Inventor: GUM, Jeffrey, C., Stevensville MT 59870 (US); FERO, Chad, Missoula MT 59803 (US)
(74) Representative: Trueman, Lucy Petra
(86) International application number: PCT/US2011/042038
(87) International publication number: WO 2012/006029

(56) References cited:
- WO-A1-2009/120859
- US-A- 5 062 386
- US-A1- 2001 009 255
- US-A1- 2002 092 617
- US-A1- 2003 000 545
- US-A1- 2005 083 575
- US-A1- 2009 071 403

## Description

### 1. Field of Invention

This invention relates to systems and methods of fabricating semiconductor materials and, in particular, to systems and methods of recovering and utilizing heat energy to reduce power consumption during semiconductor fabrication.

### 2. Discussion of Related Art

Koppl et al, in U.S. Patent No. 4,173,944, disclose a silver-plated vapor deposition chamber.

Chandra et al, in U.S. Patent No. 6,365,225 B1, disclose a cold wall reactor and method for chemical vapor deposition of bulk polysilicon.

Wan et al, in U.S. Patent Application Publication 2007/0251455 A1, disclose a method and process for the production of bulk polysilicon by chemical vapor deposition.

Martin et al, in U.S. Patent No. 4,579,080, disclose an induction heated reactor system for chemical vapor deposition.

McNeilly, in U.S. Patent No. 4,938,815, discloses a semiconductor substrate heater and reactor.

International Patent Publication No. WO2009/120859 discloses a reaction chamber system, and related devices and methods for use in the system, in which reduced power consumption can be achieved by providing a thin layer of gold on one or more components inside a reaction chamber. The reaction chamber system can be used for chemical vapor deposition. The gold coating should be maintained to a thickness of at least about 0.1 microns, and more preferably about 0.5 to 3.0 microns, to provide a suitable emissivity inside the reaction chamber, and thus reduce heat losses.

### SUMMARY OF THE INVENTION

One or more aspects of the invention are directed to a chemical vapor deposition system of a semiconductor material fabrication facility. The chemical vapor deposition system comprises a reaction chamber having a base plate and a bell jar securable to the base plate. The bell jar has a radiation shield comprised of a nickel layer, disposed on an interior surface of the bell jar, and a gold layer which is disposed on the nickel layer. The bell jar further comprises a cooling conduit having a conduit inlet port and a conduit outlet port, wherein the cooling conduit is in thermal communication with the radiation shield. The system can further comprise a heat exchanger that is fluidly connected at a first thermal side thereof to the cooling conduit and further fluidly connected at a second thermal side thereof to at least one unit operation of the semiconductor material fabrication facility. The radiation shield typically has an emissivity of less than about 5%. In some embodiments in accordance with some aspects of the invention, the heat exchanger is typically thermally connected to the radiation shield through a coolant or cooling fluid, which, in some cases, can consist essentially of water. The system can further comprise one or more flash drums, each of which can have an inlet that is fluidly connected to the conduit outlet port of the cooling conduit, and a vapor outlet port that is fluidly connected to an exchanger inlet port of the heat exchanger. The heat exchanger can have an exchanger outlet port that is fluidly connected upstream of the flash drum. The flash drum can have a condensate outlet port that is fluidly connected upstream of the conduit inlet port of the cooling conduit. The system can further comprise a cooler that is fluidly connected downstream from the heat exchanger and, in some cases, fluidly connected upstream of the conduit inlet port of the cooling conduit. In some configurations pertinent to some aspects of the invention, the system can further comprise one or more sources of at least one polycrystalline silicon precursor compound, each of the one or more sources is fluidly connected or connectable to a reactant inlet of the reaction chamber.

One or more aspects of the invention are directed to a method of facilitating fabricating a semiconductor material in a semiconductor fabrication facility. The method comprises providing a chemical vapor deposition system comprising a reaction chamber having a base plate and a bell jar securable to the base plate. The bell jar comprises a radiation shield with a nickel layer, which is disposed on an interior surface of the bell jar, and a gold layer which is disposed on the nickel layer. The bell jar further comprises a cooling conduit comprising a conduit inlet port and a conduit outlet port. The method further comprises fluidly connecting the cooling conduit to a heat exchanger at a first thermal side thereof, wherein the heat exchanger is fluidly connected at a second thermal side thereof to at least one unit operation of the semiconductor fabrication facility. In some cases, fluidly connecting the cooling conduit to the heat exchanger can comprise connecting the first thermal side of the heat exchanger to at least one flash drum and, in some cases, connecting at least one flash drum to the cooling conduit. In some configurations of the invention, the method of facilitating fabrication can further comprise connecting a cooling system to the cooling conduit and to the flash drum.

One or more aspects of the invention are directed to a chemical vapor deposition system comprising a reaction chamber that has a base plate and a bell jar which is securable to the base plate. The bell jar comprises a radiation shield comprised of a nickel layer that is disposed on an interior surface of the bell jar, and further comprises a gold layer that is disposed on the nickel layer. The bell jar further comprises a cooling conduit having a conduit inlet port and a conduit outlet port, wherein the cooling conduit is in thermal communication with the radiation shield.

One or more further aspects of the invention are directed to a method of fabricating a semiconductor material in a chemical vapor deposition apparatus of a semiconductor fabrication facility. The chemical vapor deposition apparatus has a reaction chamber that is at least partially defined by a bell jar having a radiation shield thereon, which is comprised of a nickel layer disposed on an interior surface of the bell jar, and a gold layer that is disposed on the nickel layer. The method of fabricating the semiconductor material comprises introducing precursor reactants into the reaction chamber, heating a filament in the reaction chamber to a temperature sufficient to promote conversion of at least a portion of the precursor reactants into the semiconductor material, and transferring at least a portion of heat energy from the reaction chamber to a process fluid of the semiconductor fabrication facility. One or more particular aspects of the invention can be directed to a method of fabricating polycrystalline silicon as the semiconductor material. The method of fabricating the semiconductor material can comprise recovering heat energy from the reaction chamber. Some configurations of the invention can involve a method of fabricating semiconductor materials wherein recovering heat energy from the reaction chamber comprises promoting heat transfer to a coolant to maintain a temperature of the radiation shield in a range of from about 200°C to about 300°C. Still other configurations of the invention can involve a method of fabricating semiconductor materials wherein recovering heat energy from the reaction chamber comprises promoting sufficient heat transfer to the coolant to maintain the temperature of the radiation shield in a range of from about 200°C to about 250°C. Yet other configurations of the invention can involve a method of fabricating semiconductor materials wherein recovering heat energy from the reaction chamber comprises circulating water through a cooling conduit in thermal communication with the radiation shield, and wherein transferring at least a portion of the recovered heat energy from the reaction chamber comprises vaporizing at least a portion of the water into flash steam in a flash vaporizer and heating the process fluid with the flash steam. Still further configurations of the invention can involve a method of fabricating semiconductor materials wherein transferring at least a portion of heat energy from the reaction chamber comprises vaporizing at least a portion of a coolant, transferring at least a portion of the vaporized coolant to a heat exchanger, and condensing at least a portion of the vaporized coolant in the heat exchanger. In some configurations directed to methods of fabricating semiconductor materials of the invention, transferring at least a portion of the recovered heat energy comprises heating the process fluid in a reboiler of the semiconductor fabrication facility.

One or more aspects of the invention are directed to a method of producing polycrystalline silicon in a reaction chamber of a chemical vapor deposition apparatus. The method comprises promoting conversion of silicon precursor reactants into polycrystalline silicon at a net reaction chamber power consumption rate of less than 50 KW·hr per Kg of polycrystalline silicon produced, wherein the reaction chamber is at least partially defined by a bell jar having a radiation shield thereon that is comprised of a nickel layer disposed on an interior surface thereof, and a gold layer disposed on the nickel layer and having an emissivity of less than 5%. The method of producing polycrystalline silicon can further comprise transferring heat energy from the reaction chamber to a heat exchanger of a polycrystalline silicon facility. In some configurations of the invention, the method of producing polycrystalline silicon can further comprise regulating at least one operating condition of a coolant disposed to receive at least a portion of heat energy from the reaction chamber. In accordance with some embodiments of the invention directed to methods of producing polycrystalline silicon, regulating the at least one operating condition of the coolant can comprise adjusting a flow rate of the coolant flowing through a cooling conduit that provides thermal communication between the reaction chamber and the heat exchanger. In accordance with other embodiments of the invention directed to methods of producing polycrystalline silicon, regulating the at least one operating condition of the coolant can comprise maintaining the gold layer at a maximum temperature in a range of from about 200°C to about 300°C during production of the polycrystalline silicon.

One or more aspects of the invention are directed to the use of a chemical vapor deposition system to facilitate fabricating a semiconductor material in a semiconductor fabrication facility. The chemical vapor deposition system comprises a reaction chamber that has a base plate and a bell jar secured to the base plate. The bell jar comprises a cooling conduit comprising a conduit inlet port and a conduit outlet port wherein the cooling conduit is fluidly connected to a heat exchanger at a first thermal side thereof, the heat exchanger being fluidly connected at a second thermal side thereof to at least one unit operation of the semiconductor fabrication facility. The bell jar further comprises a radiation shield with a nickel layer disposed on an interior surface of the bell jar and a gold layer disposed on the nickel layer.

### BRIEF DESCRIPTION OF THE DRAWINGS

The accompanying drawings are not intended to be drawn to scale. In the drawings, each identical or nearly identical component that is illustrated in the various figures is represented by a like numeral. For purposes of clarity, not every component may be labeled in every drawing.

In the drawings:
FIG. 1 is a schematic illustration of a chemical vapor deposition system in accordance with one or more aspects of the invention;
FIG. 2 is a schematic illustration of a portion of a reaction chamber pertinent to one or more aspects of the invention;
FIG. 3 is a copy of a photomicrograph showing a radiation shield in accordance with one or more embodiments of the invention;
FIG. 4 is a copy of a photograph of a bell jar with a radiation shield in accordance with one or more embodiments of the invention;
FIG. 5 is a graph illustrating the reflectivity degradation of radiation shields with a gold layer, with and without utilizing a nickel layer, after exposure for about four hours at various temperatures to a gas mixture comprising hydrogen and nitrogen;
FIG. 6 is schematic illustration of a system showing an embodiment directed to recovering heat energy generated during a deposition process in accordance with one or more aspects of the invention;
FIG. 7 is schematic illustration of a system showing an embodiment directed to recovering heat energy generated during a deposition process in accordance with one or more aspects of the invention;
FIG. 8 is schematic illustration of a system showing an embodiment directed to recovering heat energy generated during a deposition process in accordance with one or more aspects of the invention; and
FIG. 9 is schematic illustration of a system showing an embodiment directed to recovering heat energy generated during a deposition process in accordance with one or more aspects of the invention.

### DETAILED DESCRIPTION

One or more aspects of the invention can provide or facilitate energy recovery operations. One or more aspects of the invention can advantageously provide or facilitate reduced energy consumption during semiconductor processing operations. One or more further aspects of the invention can provide or facilitate operating one or more components of semiconductor processing facilities at higher than conventional temperatures while producing semiconductor materials.

Some aspects of the invention can facilitate producing polycrystalline silicon in a reaction chamber of a chemical vapor deposition apparatus by promoting conversion of silicon precursor reactants into polycrystalline silicon at a net reaction chamber power consumption rate of less than 50 KW·hr per Kg of polycrystalline silicon produced. The reaction chamber is at least partially defined by a bell jar having a radiation shield thereon that is comprised of a mediating layer comprising a nickel layer which is disposed on an interior surface of the bell jar, and a reflective layer which comprises a gold layer that is disposed on the mediating layer. The reflective layer has an emissivity of less than 5% and, preferably, the reflective layer has an emissivity of less than about 1%.

Producing the polycrystalline silicon can further comprise transferring heat energy from the reaction chamber to a heat exchanger of a polycrystalline silicon facility. In some configurations of the invention, the method of producing polycrystalline silicon can further comprise regulating at least one operating condition of a coolant disposed to receive at least a portion of heat energy from the reaction chamber. In some cases, regulating the at least one operating condition of the coolant can comprise adjusting a flow rate of the coolant flowing through a cooling conduit that provides thermal communication between the reaction chamber and the heat exchanger. In accordance with other embodiments of the invention directed to methods of producing polycrystalline silicon, regulating the at least one operating condition of the coolant can comprise maintaining the gold layer at a maximum temperature in a range of from about 200°C to about 300°C during production of the polycrystalline silicon.

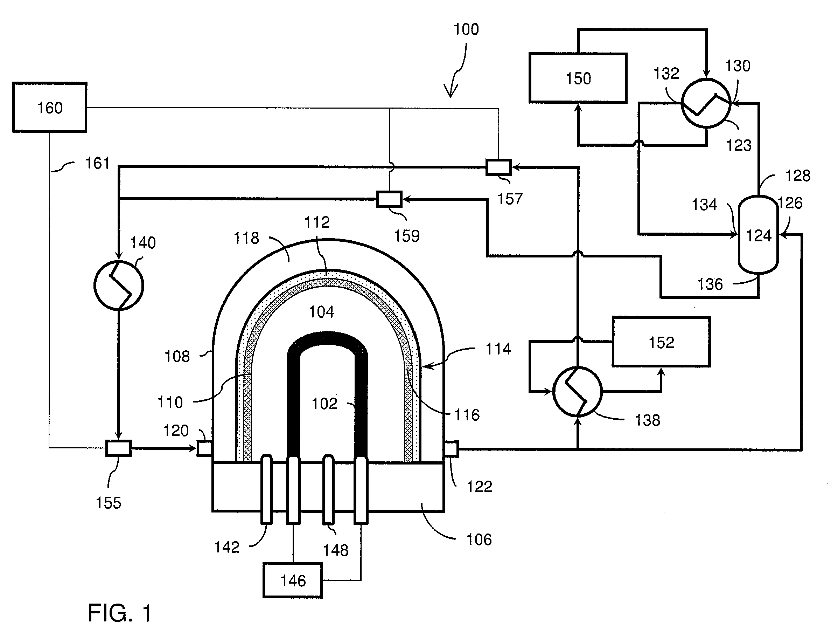

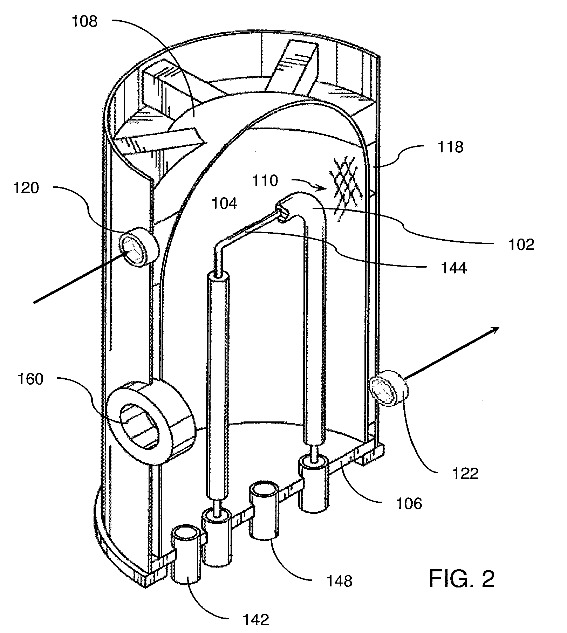

One or more particular aspects of the invention can be directed to a fabrication system for producing a semiconductor material. As schematically illustrated in FIGS. 1 and 2, one or more configurations of the invention can be directed to a fabrication system with a chemical vapor deposition system 100 for producing a semiconductor product 102. Chemical vapor deposition system 100 comprises a reaction chamber 104 defined by or having a base plate 106 and a bell jar 108 securable to base plate 106. Bell jar 108 has a radiation shield 110 comprised of a first or mediating layer 112, which is disposed on an interior surface 114 of bell jar 108, and a reflective layer 116 which is disposed on mediating layer 112. Radiation shield 110 effects at least partial reflectance of incident radiation from semiconductor product 102. Radiation shield 110 at least partially reduces radiation heat transfer to bell jar 108 from semiconductor product 102. Bell jar 108 further comprises one or more heat transfer structures such as one or more cooling conduits 118.

Bell jar 108 can be comprised of a metal such as any of the various grades of stainless steel alloys or other nickel alloys.

In configurations involving a heat transfer medium, such as a coolant or cooling fluid, the one or more conduits 118 has at least one conduit inlet port 120 and at least one conduit outlet port 122. Outlet port 122 is fluidly connected to inlet port 120 through one or more channels of the one or more cooling conduits 118. At least one of the one or more cooling conduits 118 is in thermal communication with radiation shield 110.

In some configurations pertinent to some aspects of the invention, the chemical vapor deposition system can further comprise one or more sources of at least one polycrystalline silicon precursor compound, each of the one or more sources is fluidly connected or connectable to a reactant inlet of the reaction chamber through, for example, one or more chamber inlet ports 142. During semiconductor fabrication, one or more filaments 144 is heated, typically by electrical energy from one or more power sources 146, to a temperature that promotes conversion of the one or more precursor compounds into semiconductor material product 102. Unreacted precursor compounds and byproducts from one or more semiconductor fabrication reactions can exit chamber 104 through at least one chamber outlet port 148.

Radiation shield 110 typically has an emissivity of less than about 5%. In some embodiments in accordance with some aspects of the invention, one or more heat exchangers can be thermally connected to radiation shield 110 through a cooling fluid, which, in some cases, can consist essentially of water.

In some configurations of the invention, the system can further comprise at least one heat exchanger 123 that is fluidly connected at a first thermal side thereof to the one or more cooling conduits 118. Heat exchanger 123, in certain embodiments of the invention, can be fluidly connected, at a second thermal side thereof, to at least one unit operation of a semiconductor fabrication facility.

In some configurations of the invention, the system can comprise one or more flash drums 124. Each of the one or more flash drums 124 can have an inlet 126 that is fluidly connected to conduit outlet port 122. The one or more flash drums 124 can further comprise one or more vapor outlet ports 128. Vapor outlet port 128 can be fluidly connected to an exchanger inlet port 130 of the one or more heat exchangers 123 and, in still other configurations, heat exchanger 123 can have an exchanger outlet port 132 that is fluidly connected upstream of the flash drum, typically at a second inlet port 134 thereof. The one or more flash drums 124 can further have a condensate outlet port 136 that is fluidly connected upstream of conduit inlet port 120 of cooling conduit 118.

Some further embodiments of the invention can involve a heat exchanger such as a heater 138 that is fluidly connected to conduit 118 through conduit outlet 122. Typically, heat exchanger 138 can be further fluidly connected upstream of conduit inlet 120. Thus, in some configurations of the invention, heat exchanger 138 can be fluidly connected to conduit 118 in a loop or fluid flow path. The system can further comprise one or more cooling unit operations such as cooler 140 that can be fluidly connected downstream from heat exchanger 138 and, in some cases, fluidly connected upstream of the conduit inlet port 120 of the cooling conduit. Thus, some configurations of the invention can involve including cooler 140 in a flow loop with heat exchanger 138 and conduit 118.

One or more further aspects of the invention can be directed to a method of fabricating a semiconductor material in a chemical vapor deposition apparatus of a semiconductor fabrication facility. The semiconductor material, in certain applications of the invention can be polycrystalline silicon. Fabricating the semiconductor material 102 comprises introducing at least one precursor reactant into reaction chamber 104, heating filament 144 in reaction chamber 104 to a temperature sufficient to promote conversion of at least a portion of the at least one precursor reactant into semiconductor material 102, and transferring at least a portion of heat energy from the reaction chamber to a process fluid of the semiconductor fabrication facility. The method of fabricating the semiconductor material can further comprise recovering heat energy from reaction chamber 102. Recovering heat energy from the reaction chamber can comprise promoting heat transfer to a coolant to maintain a temperature of radiation shield 110 in a range of from about 200°C to about 300°C. Preferred configurations of the invention can involve recovering or transferring heat energy from the reaction chamber in an amount sufficient to maintain the temperature of the radiation shield in a range of from about 200°C to about 250°C. In accordance with a particular, non-limiting embodiment of the invention, recovering heat energy from the reaction chamber can be effected by circulating a medium, such as a heat transfer medium through a cooling conduit that is in thermal communication with the radiation shield. The heat transfer medium can be a liquid and can consist essentially of water. Promoting transfer of at least a portion of the recovered or transferred heat energy from the reaction chamber can comprise promoting a phase change in the heat transfer medium. For example, some particularly advantageous embodiments of the invention can involve vaporizing at least a portion of the heat transfer medium, e.g., water, into flash steam in a flash vaporizer or flash drum 124, and at least partially heating the process fluid with the flash steam. The process fluid can be a bottoms fluid of a distillation operation 150 of the facility. Thus, some embodiments of the invention can involve transferring heat energy generated by a semiconductor fabrication operation to another unit operation in the same facility. Recovering the generated energy, however, can involve other approaches beyond reducing the thermal loads of the fabrication facility. For example, recovering heat energy from the reaction chamber can involve utilizing at least a portion of the heat energy to reduce, at least partially, heating requirements of one or more ancillary units. Such ancillary units can be heaters or other hot water utilities in the same or adjacent buildings, facilities, or structures. For example, the systems and techniques of the invention can involve thermally connecting at least one heating load 152 to the reaction chamber through heat exchanger 138. Heating load 152 can be, for example, a hot water heater in an industrial, commercial, or residential building.

In configurations of the invention that advantageously utilize phase changes to facilitate heat transfer, transferring at least a portion of heat energy from the reaction chamber can comprise vaporizing at least a portion of a coolant in flash drum 124, transferring at least a portion of the vaporized coolant to heat exchanger 123, and condensing at least a portion of the vaporized coolant in heat exchanger 123, which can be, for example, a reboiler of a semiconductor fabrication facility.

Thus, non-limiting embodiments of the invention can involve configurations that include heat transfer from the deposition system to a heat exchanger and provide at least a portion of the heating burden thereof, heat transfer from the deposition system with a phase change of a cooling fluid and further heat transfer to a heat exchanger to receive latent heat, and heat transfer with a mediating heat exchanger having a second circulating heat transfer medium that is in thermal communication with a heating load.

The temperature of the radiation shield can be regulated to a target temperature or a target or desired temperature range by, for example, adjusting a flow rate of the cooling fluid, adjusting the temperature of the cooling fluid, or both. For example, the flow rate of the cooling fluid introduced into conduit 118 can be increased or decreased by actuating one or more flow control devices, such as any of valves 155, 157, and 159, which, in turn can decrease or increase the temperature of the cooling fluid exiting port 122. Adjusting the temperature of the cooling fluid can be effected, for example, by increasing or decreasing the heat transfer rate at cooler 140, by adjusting one or more operating conditions of any one or more of flash drum 124, heat exchanger 123, and heat exchanger 138. One or more controllers 160 can be utilized to generate one or more control signals 161 that actuates any one of the flow control devices, adjusts a heat transfer rate through cooler 140, or any operating parameter of any of flash drum 124, heat exchanger 123, and heat exchanger 138.

Further aspects of the invention can be directed to a method of facilitating fabricating a semiconductor material. The method of facilitating semiconductor material fabrication comprises providing a chemical vapor deposition system comprising at least one reaction chamber. Each of the at least one reaction chamber has a base plate and a bell jar securable to the base plate. The bell jar comprises a radiation shield with a mediating layer, which is a nickel layer, which is disposed on an interior surface of the bell jar, and a reflective layer, which is a gold layer, disposed on the mediating layer. The reflective layer preferably has an emissivity of less than about 5%, more preferably, less than about 1%. The method of facilitating semiconductor material fabrication involves fluidly connecting a cooling conduit, which is in thermal communication with the radiation shield, to a first thermal side of one or more heat exchangers. The method of facilitating semiconductor fabrication involves fluidly connected a second thermal side of the heat exchanger to at least one unit operation of the semiconductor fabrication facility. In existing facilities where the heat exchanger is a preinstalled or existing unit operation, pertinent aspects of the invention can thus involve retrofitting one or more existing heat exchangers to be in thermal communication with the radiation shield through the cooling conduit.

In some configurations of the invention, fluidly connecting the cooling conduit to the heat exchanger can comprise connecting the first thermal side of the heat exchanger to at least one flash drum and, in some cases, connecting at least one flash drum to the cooling conduit. In accordance with other configurations of the invention, the method of facilitating fabrication can further comprise connecting a cooling system to the cooling conduit and to the flash drum.

### Examples

The functions and advantages of these and other embodiments of the invention can be further understood from the examples below, which illustrate the benefits and/or advantages of the one or more systems and techniques of the invention but do not exemplify the full scope of the invention.

Although water could be utilized in some of the following examples as a heat transfer medium, any suitable fluid that can facilitate heat transfer from at least one reaction chamber, as a heating source, and further be vaporized to effect transfer of latent heat to one or more heat receiving apparatus or heating loads can be utilized in accordance with one or more aspects of the invention. For example, propane can be utilized in the heating-vaporization-cooling/condensation cycle to facilitate recovery and transfer of the generated heat to provide at least a portion of the nominal heating burden of the one or more heating loads.

### Example 1

This example describes an embodiment of the present invention.

A stainless steel bell jar was fabricated to have a radiation shield in accordance with the present invention. A first layer comprising nickel was directly applied on the stainless steel surface of the bell jar by conventional techniques to a thickness of less than about 30 µm. A second layer comprising gold was directly applied to the first layer of nickel by conventional techniques to a thickness of less than about 5 µm.

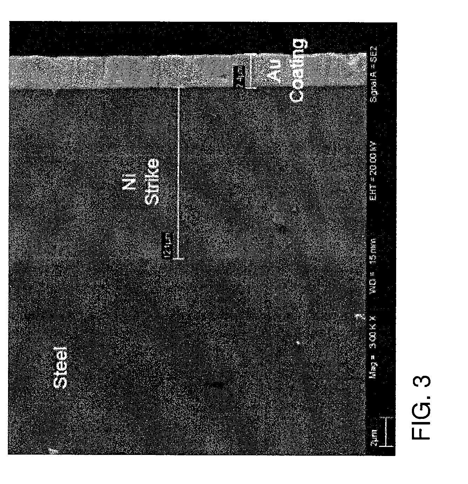

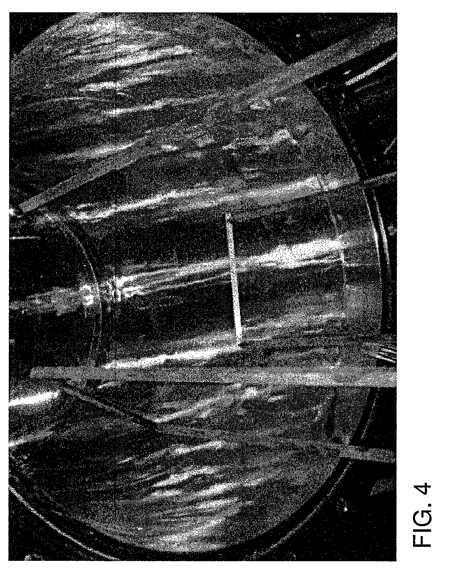

FIG. 3 shows a cross section of a portion of bell jar with the radiation shield in accordance with some aspects of the invention. The surface of the stainless steel bell jar is noted as "Steel." The first layer of nickel is noted as "Ni Strike" layer and the second layer of gold, applied on the first layer of nickel is noted as "Au Coating." FIG. 4 shows the bell jar having the radiation shield in accordance with some aspects of the invention.

It is believed that the nickel layer serves to promote adhesion of the gold material to the stainless steel surface and as a barrier layer between the stainless steel surface and the gold layer in service at temperatures of as much as 300°C.

### Example 2

This example compares the performance and observations of a system utilizing a radiation shield having a nickel layer and a gold layer to a radiation shield consisting of a gold layer only.

Several stainless steel samples were prepared to have a nickel/gold (Ni-Au Coating) radiation shield in accordance with the invention applied thereon and in substantial accordance with Example 1 above. Stainless steel samples were also prepared to have a radiation shield consisting only of a gold layer (Au Coating).

The several samples were exposed to a mixture of hydrogen and nitrogen gas for about four hours at various temperatures. After exposure at the various temperatures, the reflectivity of each of the surfaces of the samples was evaluated.

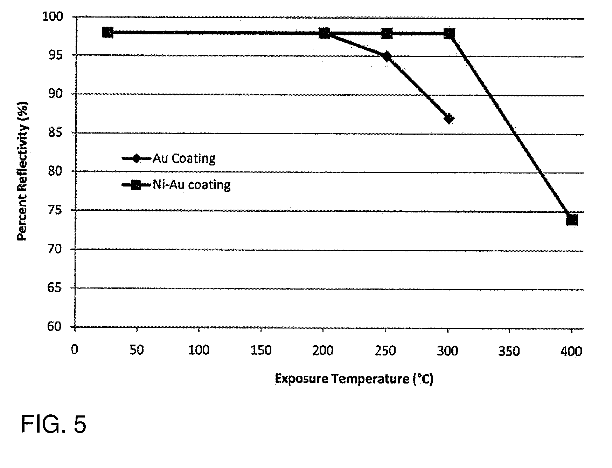

As shown in FIG. 5, the reflectivity of the Au Coating was stable and did not exhibit a decrease in reflectivity while in service at temperatures of about 200°C or less. At service temperatures greater than about 200°C, however, the reflectivity of the radiation shield having a gold layer alone decreased. In contrast, the radiation shield having nickel and gold layers in accordance with the present invention did not exhibit reflectivity degradation in service temperatures of less than or about 300°C.

This example thus supports utilization of a radiation shield that can be utilized at surface temperatures in a range of from about 200°C to about 300°C.

### Example 3

This example prophetically describes an embodiment of the invention pertinent to recovering heat from a reaction chamber by generating steam that could then be utilized to transfer latent heat to a heat load, with associated production of a condensate.

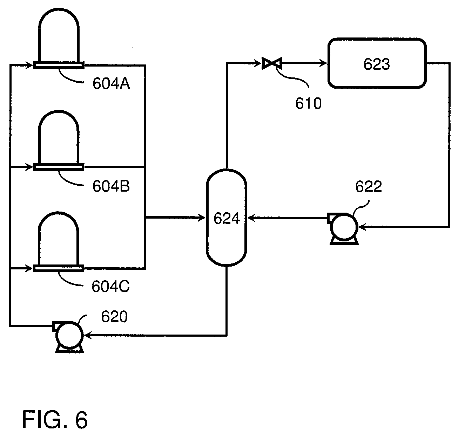

With reference to the system exemplarily presented in FIG. 6, water flowing at about 100 m³/hr could be heated to a temperature of about 156.2°C from heat generated in reaction chambers of chemical vapor deposition systems 604A, 604B, and 604C. The heated water could be flashed in one or more steam drums 624 to create steam at a pressure of about 2.8 bar (gauge). At such pressure, the saturated steam temperature is expected to be about 142°C. Saturated steam, at a pressure of about 2.1 bar (gauge) from flash drum 624 could then be condensed and at least partially heat a process fluid in, for example, one or more heat exchangers 623 thereby at least partially providing a portion of the heating burden thereof. The flash pressure could be controlled by utilizing a valve 610. Condensate from heat exchanger 623 could then be returned to flash drum 624 by one or more condensate pumps 622. The heat transfer medium, including the condensate, could be circulated from drum 624 and reheated in the reaction chambers by one or more circulation pumps 620.

A cooler could be utilized to cool the water before being introduced into the deposition system to cool the reaction chambers.

The expected total energy delivered would be about 21,637 KW from 20 reaction chambers operating at about a 70% online base for an approximately 4,000 MTA polycrystalline silicon plant.

### Example 4

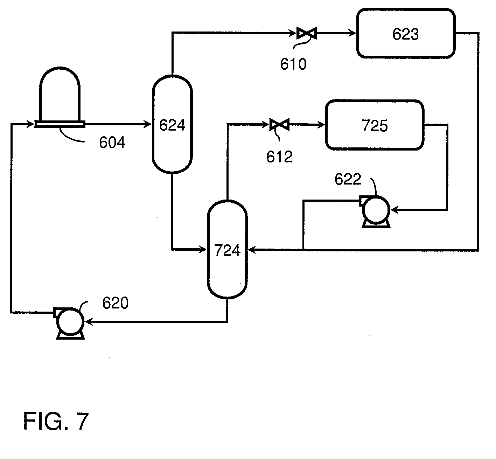

This example prophetically describes a variant of the embodiment of the invention presented in Example 3. This variant could be configured to provide steam at a first pressure from a first flash drum 624 and steam at a second pressure, lower than the first pressure, by utilizing a second vaporizer or second flash drum 724, as exemplarily shown in FIG. 7. As in the configuration presented in Example 3, vaporized steam from first flash drum 624 could be utilized to supplement at least a portion of the heating burden of a first heating operation 623. Condensate from first heat heating operation 623 could be transferred to second flash drum 724. Saturated water from first flash drum 624 could be transferred into second flash drum 724. In second flash drum 724, water could be vaporized to a lower pressure steam, which could be utilized to supply at least a portion of the heating burden of secondary heating operation 725. Condensate from secondary heating operation 725 could be returned to second flash drum 724 by a condensate pump 622. The heat transfer medium could be circulated to be reheated in the reaction chambers of the plurality of deposition systems 604 to a temperature of about 156.2°C. A first valve 610 could be utilized to facilitate generation of saturated steam in first flash drum 624 at pressure of about 4.2 bar (gauge) and an associated temperature of about 142°C, which could provide saturated utilizable steam at a pressure of about 3.5 bar (gauge) to first heating operation 623. A second valve 612 could be utilized to facilitate generation of low pressure saturated steam in second flash drum 724, at a pressure of about 2.8 bar (gauge) and an associated temperature of about 135°C, which could provide utilizable saturated low pressure steam at a pressure of about 2.1 bar (gauge) to secondary heating operation 725.

The expected aggregate heat energy that could be delivered to the first heating operation is about 4,191 KW and the expected aggregate heat energy that could be delivered to the second heating operation is about 17,447 KW, based on an approximately 4,000 MTA polycrystalline silicon facility having 20 reaction chambers operating at an online base of about 70%.

### Example 5

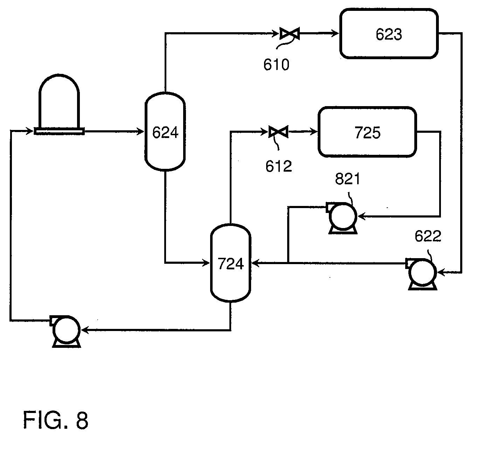

This example describes a further variant of Example 4. In this prophetic configuration, exemplarily illustrated in FIG. 8, a first flash drum 624 could be operated at a pressure of about 3.5 bar (gauge) by actuating first valve 610 accordingly so as to provide utilizable saturated steam at a pressure of about 2.8 bar (gauge) and an associated temperature of about 142°C to first heating operation 623. A second flash drum 724 could be operated to provide saturated steam at a pressure of about 2.1 bar (gauge) with an associated temperature of about 135°C to a secondary heating operation 725 by actuating a second valve 612 accordingly. Condensate from first heating operation 623 could be transferred to second flash drum 724 by a first condensate pump 622. Condensate from secondary heating operation 725 could be transferred into second flash drum 724 by a second condensate pump 821.

In this prophetic example, the expected aggregate heat energy that could be provided to the at least one first heating operation is about 12,513 KW and the expected aggregate heat energy delivered to the at least one second heating operation is about 9,124 KW, based on an approximately 4,000 MTA polycrystalline silicon facility having 20 reaction chambers operating at an online base of about 70%.

### Example 6

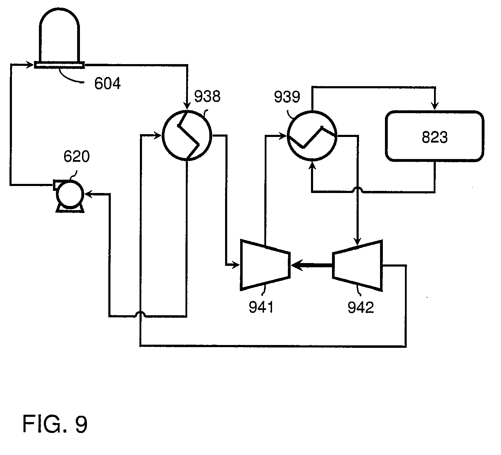

This example describes another variant of Example 3. In this prophetic configuration, exemplarily illustrated in FIG. 9, water could be circulated by circulation pump 620 and heated in a plurality of deposition systems 604. The heated water could provide heat energy to a first thermal side of a first heat exchanger 938 and raise the temperature of a thermal fluid flowing through a second thermal side of first heat exchanger 938. One or more compressors 941 could then be utilized to raise the pressure of the thermal fluid from heat exchanger 938, thereby raising the temperature thereof. The heated, pressurized thermal fluid could then be flashed to generate high pressure steam that could be utilized in a second heat exchanger 939 which could provide heat to one or more heating operations 823 by utilizing another circulating heat transfer fluid. Alternatively, the heated, pressurized thermal fluid could be directly utilized to satisfy at least a portion of the heating burden of the one or more heating operations 823.

Optionally, an expander, such as a turbine 942, could be utilized to extract shaft work by depressurizing the thermal fluid. The shaft work could be delivered to compressor 941 and supplement at least a portion of the required shaft work involved in raising the pressure of the thermal fluid in compressor 941. Thermal fluid from turbine 942 could be reheated in the second thermal side of first heat exchanger 938 by heated water from the plurality of systems 604.

Having now described some illustrative embodiments of the invention, it should be apparent to those skilled in the art that the foregoing is merely illustrative and not limiting, having been presented by way of example only. Numerous modifications and other embodiments are within the scope of one of ordinary skill in the art and are contemplated as falling within the scope of the invention. In particular, although many of the examples presented herein involve specific combinations of method acts or system elements, it should be understood that those acts and those elements may be combined in other ways to accomplish the same objectives.

Those skilled in the art should appreciate that the parameters and configurations described herein are exemplary and that actual parameters and/or configurations will depend on the specific application in which the systems and techniques of the invention are used. Those skilled in the art should also recognize or be able to ascertain, using no more than routine experimentation, equivalents to the specific embodiments of the invention. For example, any controller can be utilized to implement one or more embodiments of the present invention such as, but not limited to programmable logic controllers (PLC). Other devices that can automate any of the operational tasks of the system can also be utilized. Likewise, vaporizing water to produce saturated steam can be facilitated by utilizing a valve upstream of a flash drum. It is therefore to be understood that the embodiments described herein are presented by way of example only and that, within the scope of the appended claims and equivalents thereto; the invention may be practiced otherwise than as specifically described.

Moreover, it should also be appreciated that the invention is directed to each feature, system, subsystem, or technique described herein and any combination of two or more features, systems, subsystems, or techniques described herein and any combination of two or more features, systems, subsystems, and/or methods, if such features, systems, subsystems, and techniques are not mutually inconsistent, is considered to be within the scope of the invention as embodied in the claims. Further, acts, elements, and features discussed only in connection with one embodiment are not intended to be excluded from a similar role in other embodiments.

As used herein, the term "plurality" refers to two or more items or components. The terms "comprising," "including," "carrying," "having," "containing," and "involving," whether in the written description or the claims and the like, are open-ended terms, i.e., to mean "including but not limited to." Thus, the use of such terms is meant to encompass the items listed thereafter, and equivalents thereof, as well as additional items. Only the transitional phrases "consisting of' and "consisting essentially of," are closed or semi-closed transitional phrases, respectively, with respect to the claims. Use of ordinal terms such as "first," "second," "third," and the like in the claims to modify a claim element does not by itself connote any priority, precedence, or order of one claim element over another or the temporal order in which acts of a method are performed, but are used merely as labels to distinguish one claim element having a certain name from another element having a same name (but for use of the ordinal term) to distinguish the claim elements.

## Claims

1. A chemical vapor deposition system comprising a reaction chamber comprising:
a base plate;
a bell jar securable to the base plate, the bell jar comprising a cooling conduit having a conduit inlet port
and a conduit outlet port; and
a radiation shield comprised of a nickel layer disposed on an interior surface of the bell jar, and a gold layer disposed on the nickel layer, the cooling conduit in thermal communication with the radiation shield.

2. The chemical vapor deposition system of claim 1, where the system is the chemical vapor deposition system of a semiconductor material fabrication facility, and wherein the chemical vapor deposition system further comprises:
a heat exchanger fluidly connected at a first thermal side thereof to the cooling conduit and further fluidly connected at a second thermal side thereof to at least one unit operation of the semiconductor material fabrication facility.

3. The chemical vapor deposition system of claim 2, wherein any one or more of the following applies:
(a) the radiation shield has an emissivity of less than about 5%;
(b) the heat exchanger is thermally connected to the radiation shield through a coolant consisting essentially of water; and
(c) the system further comprises a flash drum having an inlet fluidly connected to the conduit outlet port of the cooling conduit, and a vapor outlet port fluidly connected to an exchanger inlet port of the heat exchanger;
wherein optionally the heat exchanger has an exchanger outlet port fluidly connected upstream of the flash drum;
wherein optionally the flash drum has a condensate outlet port fluidly connected upstream of the conduit inlet port of the cooling conduit;
wherein optionally the system further comprises a cooler fluidly connected downstream from the heat exchanger and upstream of the conduit inlet port of the cooling conduit.

4. The chemical vapor deposition system of claim 3, further comprising a source of at least one polycrystalline silicon precursor compound fluidly connectable to a reactant inlet of the reaction chamber.

5. A method of facilitating fabricating a semiconductor material in a semiconductor fabrication facility, the method comprising:
providing a chemical vapor deposition system comprising:
a reaction chamber having a base plate;
a bell jar securable to the base plate, the bell jar comprising a cooling conduit comprising a conduit inlet port and a conduit outlet port; and
a radiation shield with a nickel layer disposed on an interior surface of the bell jar and a gold layer disposed on the nickel layer; and
fluidly connecting the cooling conduit to a heat exchanger at a first thermal side thereof, the heat exchanger fluidly connected at a second thermal side thereof to at least one unit operation of the semiconductor fabrication facility.

6. The method of claim 5, wherein fluidly connecting the cooling conduit to the heat exchanger comprises connecting the first thermal side of the heat exchanger to a flash drum and connecting the flash drum to the cooling conduit, wherein optionally the method further comprises connecting a cooling system to the cooling conduit and to the flash drum.

7. A method of fabricating a semiconductor material in a chemical vapor deposition apparatus of a semiconductor fabrication facility, the chemical vapor deposition apparatus having a reaction chamber that is at least partially defined by a bell jar having a radiation shield thereon that is comprised of a nickel layer disposed on an interior surface of the bell jar and a gold layer disposed on the nickel layer, the method of fabricating the semiconductor material comprising:
introducing precursor reactants into the reaction chamber;
heating a filament in the reaction chamber to a temperature sufficient to promote conversion of at least a portion of the precursor reactants into the semiconductor material; and
transferring at least a portion of heat energy from the reaction chamber to a process fluid of the semiconductor fabrication facility.

8. The method of claim 7, wherein the semiconductor material is polycrystalline silicon.

9. The method of claim 7, further comprising recovering heat energy from the reaction chamber.

10. The method of claim 9 wherein recovering heat energy from the reaction chamber comprises promoting heat transfer to a coolant to maintain a temperature of the radiation shield in a range of from about 200°C to about 300°C.

11. The method of claim 10, wherein recovering heat energy from the reaction chamber comprises promoting sufficient heat transfer to the coolant to maintain the temperature of the radiation shield in a range of from about 200°C to about 250°C.

12. The method of claim 9, wherein recovering heat energy from the reaction chamber comprises circulating water through a cooling conduit in thermal communication with the radiation shield, and wherein transferring at least a portion of the recovered heat energy from the reaction chamber comprises vaporizing at least a portion of the water into flash steam in a flash vaporizer and heating the process fluid with the flash steam.

13. The method of claim 7, wherein transferring at least a portion of heat energy from the reaction chamber comprises vaporizing at least a portion of a coolant, transferring at least a portion of the vaporized coolant to a heat exchanger, and condensing at least a portion of the vaporized coolant in the heat exchanger.

14. The method of claim 7, wherein transferring at least a portion of the recovered heat energy comprises heating the process fluid in a reboiler of the semiconductor fabrication facility.

15. A method of producing polycrystalline silicon in a reaction chamber of a chemical vapor deposition apparatus, the method comprising promoting conversion of silicon precursor reactants into polycrystalline silicon at a net reaction chamber power consumption rate of less than 50 KW.hr per Kg of polycrystalline silicon produced, wherein the reaction chamber is at least partially defined by a bell jar having a radiation shield thereon that is comprised of a nickel layer disposed on an interior surface thereof, and a gold layer disposed on the nickel layer and having an emissivity of less than 5%.

16. The method of claim 15, further comprising transferring heat energy from the reaction chamber to a heat exchanger of a polycrystalline silicon facility.

17. The method of claim 16, further comprising regulating at least one operating condition of a coolant disposed to receive at least a portion of heat energy from the reaction chamber.

18. The method of claim 17, wherein
(a) regulating the at least one operating condition of the coolant comprises adjusting a flow rate of the coolant flowing through a cooling conduit that provides thermal communication between the reaction chamber and the heat exchanger; or wherein
(b) regulating the at least one operating condition of the coolant comprises maintaining the gold layer at a maximum temperature in a range of from about 200°C to about 300°C during production of the polycrystalline silicon.

19. The use of a chemical vapor deposition system to facilitate fabricating a semiconductor material in a semiconductor fabrication facility,
wherein the chemical vapor deposition system comprises:
a reaction chamber having a base plate;
a bell jar secured to the base plate, the bell jar comprising a cooling conduit comprising a conduit inlet port and a conduit outlet port; and
a radiation shield with a nickel layer disposed on an interior surface of the bell jar and a gold layer disposed on the nickel layer;
and wherein the cooling conduit is fluidly connected to a heat exchanger at a first thermal side thereof,
the heat exchanger being fluidly connected at a second thermal side thereof to at least one unit operation of the semiconductor fabrication facility .

## Patentansprüche

1. Ein chemisches Gasphasenabscheidungssystem mit einer
Reaktionskammer, das Folgendes aufweist:
eine Grundplatte;
eine Glasglocke, die an der Grundplatte befestigt werden kann, die Glasglocke weist dabei eine Kühlleitung mit einer Rohreinlassöffnung und einer Rohrauslassöffnung auf; und
ein Strahlungsschild, das eine Nickelschicht aufweist, die an einer Innenfläche der Glasglocke aufgebracht ist, und eine Goldschicht, die über der Nickelschicht aufgebracht ist, die Kühlleitung steht dabei in thermischem Austausch mit dem Strahlungsschild.

2. Das chemische Gasphasenabscheidungssystem gemäß Anspruch 1, wobei das System das chemische Gasphasenabscheidungssystem einer Halbleitermaterial-Fertigungsanlage ist, und wobei das chemische Gasphasenabscheidungssystem darüberhinaus Folgendes aufweist:
einen Wärmetauscher, der an einer ersten Thermoseite in Fluidverbindung mit der Kühlleitung steht und darüberhinaus an einer zweiten Thermoseite in Fluidverbindung mit mindestens einer Grundoperation der Halbleitermaterial-Fertigungsanlage steht.

3. Das chemische Gasphasenabscheidungssystem gemäß Anspruch 2, wobei einer oder mehrere der folgenden Punke gilt/gelten:
(a) das Strahlungsschild hat einen Emissionsgrad von weniger als ungefähr 5%;
(b)der Wärmetauscher ist thermisch mit dem Strahlungsschild über ein Kühlmedium, das im Allgemeinen Wasser enthält, verbunden; und
(c) das System weist darüberhinaus eine Entspannungstrommel mit einem Einlass auf, der in Fluidverbindung mit der Rohrauslassöffnung der Kühlleitung steht, und eine Dampfauslassöffnung, die in Fluidverbindung mit einer Tauschereinlassöffnung des Wärmetauschers steht;
wobei optional der Wärmetauscher eine Tauscherauslassöffnung in vorgeschalteter Fluidverbindung mit der Entspannungstrommel hat;
wobei optional die Entspannungstrommel eine Kondensatauslassöffnung in vorgeschalteter Fluidverbindung mit der Rohreinlassöffnung der Kühlleitung hat;
wobei optional das System darüberhinaus einen Kühler aufweist, der nachgeschaltet in Fluidverbindung mit dem Wärmetauscher und vorgeschaltet mit der Rohreinlassöffnung der Kühlleitung steht.

4. Das chemische Gasphasenabscheidungssystem gemäß Anspruch 3, das darüberhinaus eine Quelle mindestens einer polykristallinen Silikon-Precursor-Verbindung aufweist, die in Fluidverbindung mit einem Reaktanteneinlass der Reaktionskammer stehen kann.

5. Ein Verfahren für die Herstellung eines Halbleitermaterials in einer Halbleiter-Fertigungsanlage, das Verfahren weist dabei Folgendes auf:
die Bereitstellung eines chemischen Gasphasenabscheidungssystems das Folgendes aufweist:
eine Reaktionskammer mit einer Grundplatte;
eine Glasglocke, die an der Grundplatte befestigt werden kann, die Glasglocke weist dabei eine Kühlleitung mit einer Rohreinlassöffnung und einer Rohrauslassöffnung auf; und
ein Strahlungsschild mit einer Nickelschicht, die an einer Innenfläche der Glasglocke aufgebracht ist, und eine Goldschicht, die über der Nickelschicht aufgebracht ist, und
eine Fluidverbindung der Kühlleitung mit einem Wärmetauscher an einer ersten Thermoseite, der Wärmetauscher steht dabei an einer zweiten Thermoseite in Fluidverbindung mit mindestens einer Grundoperation der Halbleitermaterial-Fertigungsanlage.

6. Das Verfahren gemäß Anspruch 5, wobei die Fluidverbindung des Kühlrohrs mit dem Wärmetauscher die Verbindung der ersten Thermoseite des Wärmetauschers mit einer Entspannungstrommel und die Verbindung der Entspannungstrommel mit der Kühlleitung aufweist, wobei optional das Verfahren darüberhinaus den Anschluss eines Kühlsystems an die Kühlleitung und an die Entspannungstrommel aufweist.

7. Ein Verfahren für die Herstellung eines Halbleitermaterials in einer chemischen Gasphasenabscheidungsvorrichtung einer Halbleiter-Fertigungsanlage, die chemische Gasphasenabscheidungsvorrichtung hat dabei eine Reaktionskammer, die zumindest teilweise durch eine Glasglocke mit einem Strahlungsschild daran definiert ist, das eine Nickelschicht an einer Innenfläche der Glasglocke und eine Goldschicht über der Nickelschicht aufweist, das Verfahren der Halbleitermaterial-Herstellung weist dabei Folgendes auf:
die Einführung eines Precursor-Reaktanten in die Reaktionskammer;
die Erhitzung eines Filaments in der Reaktionskammer auf eine Temperatur, die ausreicht, um die Umwandlung zumindest eines Teils der Precursor-Reaktanten in das Halbleitermaterial zu fördern; und
die Übertragung zumindest eines Teils der Wärmeenergie aus der Reaktionskammer in eine Prozessflüssigkeit der Halbleiter-Fertigungsanlage.

8. Das Verfahren gemäß Anspruch 7, wobei das Halbleitermaterial polykristallines Silikon ist.

9. Das Verfahren gemäß Anspruch 7, das darüberhinaus die Wiedergewinnung der Wärmeenergie aus der Reaktionskammer aufweist:

10. Das Verfahren gemäß Anspruch 9, wobei die Wiedergewinnung der Wärmeenergie aus der Reaktionskammer die Förderung des Wärmetransfers zu einem Kühlmedium aufweist, um eine Temperatur des Strahlungsschilds in einem Bereich von ungefähr 200°C bis ungefähr 300°C aufrechtzuerhalten.

11. Das Verfahren gemäß Anspruch 10, wobei die Wiedergewinnung der Wärmeenergie aus der Reaktionskammer die Förderung des ausreichenden Wärmetransfers zum Kühlmedium aufweist, um die Temperatur des Strahlungsschilds in einem Bereich von ungefähr 200°C bis ungefähr 250°C aufrechtzuerhalten.

12. Das Verfahren gemäß Anspruch 9, wobei die Wiedergewinnung der Wärmeenergie aus der Reaktionskammer die Zirkulation von Wasser durch ein Rohrsystem in thermischem Austausch mit dem Strahlungsschild, und wobei die Übertragung zumindest eines Teils der wiedergewonnenen Wärmeenergie aus der Reaktionskammer das Verdampfen zumindest eines Teils des Wassers in einen Entspannungsdampf in einem Entspannungsverdampfer und die Erhitzung der Prozessflüssigkeit mit dem Entspannungsdampf aufweist.

13. Das Verfahren gemäß Anspruch 7, wobei die Übertragung zumindest eines Teils der Wärmeenergie aus der Reaktionskammer das Verdampfen zumindest eines Teils eines Kühlmediums, die Übertragung zumindest eines Teils des verdampften Kühlmediums an einen Wärmetauscher und die Kondensation zumindest eines Teils des verdampften Kühlmediums im Wärmetauscher aufweist.

14. Das Verfahren gemäß Anspruch 7, wobei die Übertragung zumindest eines Teils der rückgewonnenen Wärmeenergie die Erhitzung der Prozessflüssigkeit in einem Verdampfer der Halbleiter-Fertigungsanlage aufweist.

15. Ein Verfahren für die Herstellung polykristallinen Silikons in einer Reaktionskammer einer chemischen Gasphasenabscheidungsvorrichtung, das Verfahren weist dabei die Förderung der Umwandlung von Silikon-Precursor-Reaktanten in polykristallines Silikon bei einer Reaktionskammer-Netto-Stromverbrauchsrate unter 50 kW/Std pro kg des hergestellten polykristallinen Silikons auf, wobei die Reaktionskammer zumindest teilweise durch eine Glasglocke mit einem Strahlungsschild daran definiert ist, die eine Nickelschicht an einer ihrer Innenflächen und eine Goldschicht aufweist, die auf der Nickelschicht aufgebracht ist und einen Emissionsgrad unter 5% hat.

16. Das Verfahren gemäß Anspruch 15, das darüberhinaus die Übertragung der Wärmeenergie aus der Reaktionskammer zum Wärmetauscher einer polykristallinen Silikon-Fabrik aufweist.

17. Das Verfahren gemäß Anspruch 16, das darüberhinaus die Regulierung zumindest einer Betriebsbedingung eines Kühlmediums, das so angeordnet ist, dass es zumindest einen Teil der Wärmeenergie aus der Reaktionskammer empfangen kann, aufweist.

18. Das Verfahren gemäß Anspruch 17, wobei
(a) die Regulierung der zumindest einen Betriebsbedingung des Kühlmediums die Einstellung einer Durchflussmenge des durch eine Kühlleitung fließenden Kühlmediums, das den thermischen Austausch zwischen der Reaktionskammer und dem Wärmetauscher bereitstellt, aufweist; oder wobei
(b) die Regulierung der zumindest einen Betriebsbedingung des Kühlmediums die Aufrechterhaltung der Goldschicht bei einer Höchsttemperatur in einem Bereich von ungefähr 200°C bis ungefähr 300°C während der Herstellung des polykristallinen Silikons aufweist.

19. Die Verwendung eines chemischen Gasphasenabscheidungssystems, um die Herstellung eines Halbleitermaterials in einer Halbleiter-Fertigungsanlage zu ermöglichen,
wobei das chemische Gasphasenabscheidungssystem Folgendes aufweist:
eine Reaktionskammer mit einer Grundplatte;
eine Glasglocke, die an der Grundplatte befestigt ist, die Glasglocke weist dabei eine Kühlleitung mit einer Rohreinlassöffnung und einer Rohrauslassöffnung auf; und
ein Strahlungsschild mit einer Nickelschicht, die an einer Innenfläche der Glasglocke aufgebracht ist, und eine Goldschicht, die über der Nickelschicht aufgebracht ist,
und wobei die Kühlleitung eine Fluidverbindung mit einem Wärmetauscher an einer ersten Thermoseite hat, der Wärmetauscher steht dabei an einer zweiten Thermoseite in Fluidverbindung mit mindestens einer Grundoperation der Halbleitermaterial-Fertigungsanlage.

## Revendications

1. Un système de dépôt chimique en phase vapeur comprenant une chambre de réaction comprenant :
une plaque de base,
une cloche à vide pouvant être fixée à la plaque de base, la cloche à vide comprenant un conduit de refroidissement possédant un orifice d'admission de conduit et un orifice de sortie de conduit, et
un écran anti-rayonnement composé d'une couche de nickel disposée sur une surface intérieure de la cloche à vide et une couche d'or disposée sur la couche de nickel, le conduit de refroidissement étant en communication thermique avec l'écran anti-rayonnement.

2. Le système de dépôt chimique en phase vapeur selon la Revendication 1, où le système est le système de dépôt chimique en phase vapeur d'une installation de fabrication d'un matériau semiconducteur et où le système de dépôt chimique en phase vapeur comprend en outre :
un échangeur thermique raccordé de manière fluidique au niveau d'un premier côté thermique de celui-ci au conduit de refroidissement et raccordé en outre de manière fluidique au niveau d'un deuxième côté thermique de celui-ci à au moins une unité opérationnelle de l'installation de fabrication d'un matériau semiconducteur.

3. Le système de dépôt chimique en phase vapeur selon la Revendication 2, où un élément quelconque ou plusieurs des suivants s'applique :
(a) l'écran anti-rayonnement possède une émissivité inférieure à environ 5%,
(b) l'échangeur thermique est raccordé thermiquement à l'écran anti-rayonnement par l'intermédiaire d'un réfrigérant consistant essentiellement d'eau, et
(c) le système comprend en outre un ballon de détente possédant une admission raccordée de manière fluidique à l'orifice de sortie de conduit du conduit de refroidissement et un orifice de sortie de vapeur raccordé de manière fluidique à un orifice d'admission d'échangeur de l'échangeur thermique,
où éventuellement l'échangeur thermique possède un orifice de sortie d'échangeur raccordé de manière fluidique en amont du ballon de détente,
où éventuellement le ballon de détente possède un orifice de sortie de condensat raccordé de manière fluidique en amont de l'orifice d'admission de conduit du conduit de refroidissement,
où éventuellement le système comprend en outre un refroidisseur raccordé de manière fluidique en aval de l'échangeur thermique et en amont de l'orifice d'admission de conduit du conduit de refroidissement.

4. Le système de dépôt chimique en phase vapeur selon la Revendication 3, comprenant en outre une source d'au moins un composé précurseur de silicium polycristallin pouvant être raccordé de manière fluidique à une admission de réactif de la chambre de réaction.

5. Un procédé de facilitation de la fabrication d'un matériau semi-conducteur dans une installation de fabrication de semi-conducteurs, le procédé comprenant :
la fourniture d'un système de dépôt chimique en phase vapeur comprenant :
une chambre de réaction possédant une plaque de base,
une cloche à vide pouvant être fixée à la plaque de base, la cloche à vide comprenant un conduit de refroidissement comprenant un orifice d'admission de conduit et un orifice de sortie de conduit, et
un écran anti-rayonnement avec une couche de nickel disposée sur une surface intérieure de la cloche à vide et une couche d'or disposée sur la couche de nickel, et
le raccordement fluidique du conduit de refroidissement à un échangeur thermique au niveau d'un premier côté thermique de celui-ci, l'échangeur thermique étant raccordé de manière fluidique au niveau d'un deuxième côté thermique de celui-ci à au moins une unité opérationnelle de l'installation de fabrication de semi-conducteurs.

6. Le procédé selon la Revendication 5, où le raccordement fluidique du conduit de refroidissement à l'échangeur thermique comprend le raccordement du premier côté thermique de l'échangeur thermique à un ballon de détente et le raccordement du ballon de détente au conduit de refroidissement, où éventuellement le procédé comprend en outre le raccordement d'un système de refroidissement au conduit de refroidissement et au ballon de détente.

7. Un procédé de fabrication d'un matériau semi-conducteur dans un appareil de dépôt chimique en phase vapeur d'une installation de fabrication de semi-conducteurs, l'appareil de dépôt chimique en phase vapeur possédant une chambre de réaction qui est au moins partiellement définie par une cloche à vide possédant un écran anti-rayonnement sur celle-ci qui est composé d'une couche de nickel disposée sur une surface intérieure de la cloche à vide et d'une couche d'or disposée sur la couche de nickel, le procédé de fabrication du matériau semi-conducteur comprenant :
l'introduction de réactifs précurseurs dans la chambre de réaction,
le chauffage d'un filament dans la chambre de réaction à une température suffisante pour promouvoir une conversion d'au moins une partie des réactifs précurseurs dans le matériau semi-conducteur, et
le transfert d'au moins une partie de l'énergie thermique de la chambre de réaction à un fluide de traitement de l'installation de fabrication de semi-conducteurs.

8. Le procédé selon la Revendication 7, où le matériau semi-conducteur est du silicium polycristallin.

9. Le procédé selon la Revendication 7, comprenant en outre la récupération d'énergie thermique à partir de la chambre de réaction.

10. Le procédé selon la Revendication 9 où la récupération d'énergie thermique à partir de la chambre de réaction comprend la promotion d'un transfert thermique vers un réfrigérant de façon à maintenir une température de l'écran anti-rayonnement dans une plage d'environ 200°C à environ 300°C.

11. Le procédé selon la Revendication 10, où la récupération d'énergie thermique à partir de la chambre de réaction comprend la promotion d'un transfert thermique suffisant au réfrigérant de façon à maintenir la température de l'écran anti-rayonnement dans une plage d'environ 200°C à environ 250°C.

12. Le procédé selon la Revendication 9, où la récupération d'énergie thermique à partir de la chambre de réaction comprend la circulation d'eau au travers d'un conduit de refroidissement en communication thermique avec l'écran anti-rayonnement, et où le transfert d'au moins une partie de l'énergie thermique récupérée à partir de la chambre de réaction comprend la vaporisation d'au moins une partie de l'eau en une vapeur de détente dans un vaporisateur de détente et le chauffage du fluide de traitement avec la vapeur de détente.

13. Le procédé selon la Revendication 7, où le transfert d'au moins une partie de l'énergie thermique à partir de la chambre de réaction comprend la vaporisation d'au moins une partie d'un réfrigérant, le transfert d'au moins une partie du réfrigérant vaporisé à un échangeur thermique, et la condensation d'au moins une partie du réfrigérant vaporisé dans l'échangeur thermique.

14. Le procédé selon la Revendication 7, où le transfert d'au moins une partie de l'énergie thermique récupérée comprend le chauffage du fluide de traitement dans un rebouilleur de l'installation de fabrication de semi-conducteurs.

15. Un procédé de production de silicium polycristallin dans une chambre de réaction d'un appareil de dépôt chimique en phase vapeur, le procédé comprenant la promotion d'une conversion de réactifs précurseurs de silicium en du silicium polycristallin à une vitesse de consommation d'énergie de chambre de réaction nette inférieure à 50 KW/heure par Kg de silicium polycristallin produit, où la chambre de réaction est au moins partiellement définie par une cloche à vide possédant un écran anti-rayonnement sur celle-ci qui est composé d'une couche de nickel disposée sur une surface intérieure de celui-ci et d'une couche d'or disposée sur la couche de nickel et possédant une émissivité inférieure à 5%.

16. Le procédé selon la Revendication 15, comprenant en outre le transfert d'énergie thermique de la chambre de réaction à un échangeur thermique d'une installation de silicium polycristallin.

17. Le procédé selon la Revendication 16, comprenant en outre la régulation d'au moins une condition opérationnelle d'un réfrigérant disposé de façon à recevoir au moins une partie de l'énergie thermique de la chambre de réaction.

18. Le procédé selon la Revendication 17, où
(a) la régulation de la au moins une condition opérationnelle du réfrigérant comprend l'ajustement d'un débit du réfrigérant s'écoulant au travers d'un conduit de refroidissement qui fournit une communication thermique entre la chambre de réaction et l'échangeur thermique, ou où
(b) la régulation de la au moins une condition opérationnelle du réfrigérant comprend le maintien de la couche d'or à une température maximale dans une plage d'environ 200°C à environ 300°C au cours de la production du silicium polycristallin.

19. L'utilisation d'un système de dépôt chimique en phase vapeur de façon à faciliter la fabrication d'un matériau semi-conducteur dans une installation de fabrication de semi-conducteurs,
où le système de dépôt chimique en phase vapeur comprend :
une chambre de réaction possédant une plaque de base,
une cloche à vide fixée à la plaque de base, la cloche à vide comprenant un conduit de refroidissement comprenant un orifice d'admission de conduit et un orifice de sortie de conduit, et
un écran anti-rayonnement avec une couche de nickel disposée sur une surface intérieure de la cloche à vide et une couche d'or disposée sur la couche de nickel,
et où le conduit de refroidissement est raccordé de manière fluidique à un échangeur thermique au niveau d'un premier côté thermique de celui-ci, l'échangeur thermique étant raccordé de manière fluidique au niveau d'un deuxième côté thermique de celui-ci à au moins une unité opérationnelle de l'installation de fabrication de semi-conducteurs.
